# EUROPÄISCHE PATENTSCHRIFT

(11) **EP 3 532 792 B1**
(45) Veröffentlichungstag und Bekanntmachung des Hinweises auf die Patenterteilung: **06.03.2024**
(21) Anmeldenummer: 17804428.5
(22) Anmeldetag: 25.10.2017
(51) Int. Cl.: F28F 13/00, H01L 23/36, H01L 23/373

(54) **FESTKÖRPER ODER BEHÄLTNIS MIT STRUKTUR ZUR TEMPERIERUNG DESSELBEN**
SOLID BODY OR CONTAINERS WITH STRUCTURE FOR CONTROLLING THE TEMPERATURE OF THE SAME
SOLIDE ET DE CONTENANT AVEC STRUCTURE DE THERMORÉGULATION DU MEME

(30) Priorität: 26.10.2016 DE 102016012795
(43) Veröffentlichungstag der Anmeldung: 04.09.2019
(73) Patentinhaber: Marchl, Peter, 96328 Küps (DE)
(72) Erfinder: Marchl, Peter, 96328 Küps (DE)
(74) Vertreter: Helge, Reiner
(86) Internationale Anmeldenummer: PCT/DE2017/000356
(87) Internationale Veröffentlichungsnummer: WO 2018/077321

(56) Entgegenhaltungen:
- WO-A1-2013/163398
- DE-A1- 10 055 454
- US-A1- 2008 149 304
- US-A1- 2010 218 512
- US-A1- 2016 069 622

## Beschreibung

Die Erfindung betrifft einen Festkörper oder ein Behältnis mit einer Struktur zur Temperierung mittels Luftstrom und / oder mit thermoelektrisch arbeitenden Temperierelementen, insbesondere im Bereich der Elektromobilität und der Elektronik, und seine Verwendung.

Die durch Arbeit (Energiezufuhr oder -verlust) entstehende Prozeßwärme oder Prozeßkälte in einem Objekt kann nur unzureichend durch eine Luftströmung abgeleitet werden, wenn die Wärmeleitfähigkeit, Oberfläche und Dichte des Objektes in einem ungünstigen Verhältnis stehen.

Höhere Anforderungen an Kühlung oder Erwärmung werden heutzutage durch Dissipation oder Zuführung von Wärmeenergie mittels Flüssigkeiten erzielt, die eine hohe Wärmeaufnahmefähigkeit besitzen. Die in der Flüssigkeit gespeicherte Energie wird dann im Folgenden an anderer Stelle wieder abgegeben oder abgegebene Energie wieder zugeführt. Durch kontinuierliche Zirkulation wird so ein Wärmeaustausch erzeugt.

Die Flüssigkeitskühlung ist zwar effektiver, verhindert aber aufgrund ihrer Komplexität und Störanfälligkeit oftmals eine Weiterentwicklung von Anwendungen.

Besonders im Segment Elektromobilität und Elektronik ist die Temperierung der installierten Batterien sowie der Leistungselektronik ein zunehmendes Problem. Da schnelle Leistungsbereitstellung wie auch schnelle Ladevorgänge hohe Anforderungen an die Temperierung der Batteriepakete stellt sowie die Umgebungstemperatur nicht statisch ist, sondern buchstäblich von Fahrzeug zu Fahrzeug und von Tag zu Tag veränderlich ist muss die Temperierung der Batteriepakete auf ihre Betriebstemperatur schnell und effizient und proaktiv erfolgen. Die im Moment eingesetzte Flüssigkeitskühlung via Wärmetauscher ist war eine bekannte und zuverlässige Technologie, hat aber Nachteile da sie ein hohes Gewicht hat, langsam und energieaufwändig und in Verbindung mit Elektrizität nur schwierig eingesetzt werden kann. Außerdem werden Austausch und Reparatur der Batteriepakete durch die vorhandenen Anschlüsse für die Kühlflüssigkeit sehr viel aufwendiger und teurer für den Endverbraucher.

Bei Anwendungen zur Kühlung von Feststoffen, Gasen und Flüssigkeiten in Behältnissen z. B. Tanks oder Rohrleitungen werden passive Kühlkörper an den Behältnissen befestigt oder als Umhüllung montiert. Die Wärmeübertragung wird dabei zwar erhöht durch effektivere Kühlung der Umgebungstemperatur, jedoch begrenzt durch die geringe direkte Übertragung zwischen den Materialien der einzelnen installierten Komponenten der Baugruppe.

Lamellen oder röhrenförmige Wärmesenker müssen ab einer bestimmten Leistungsforderung eine überproportional höhere Oberfläche und Masse zur Verfügung stellen, was zu sehr hohem Gewicht und Größe führt. Die bestehenden subtraktiven Herstellungsmethoden haben Grenzen in der Miniaturisierung und sind energie- und rohstoffaufwendig. Auch ist die Komplexität des Objektes limitiert von bestehenden Extrusions- oder Subtraktionsverfahren wie z. B. Fräsung. Dies führt zu einer Einschränkung der weiteren Entwicklung der Miniaturisierung bei gleicher Leistung, besonders im Bereich der Mikroprozessoren im mobilen Einsatz.

Der Einsatz des Peltier-Effektes wie auch des Seebeck- und Thomson-Effektes zur aktiven thermoelektrischen Temperaturkontrolle oder auch der Erzeugung von Elektrizität sind bisher durch den schlechten Wirkungsgrad der bestehenden Peltierelemente beschränkt. Der Carnot-Wirkungsgrad beschreibt diese Effizienz und wird hauptsächlich durch materialbedingte schlechte Überleitung der Elektronenpotentiale zwischen den einzelnen Materialien im Element beeinflußt. Dies führt zu einem Carnot-Wirkungsgrad von 10 %. Dies ist wenig im Vergleich zu einer Kältemaschine oder Wärmemaschine, jedoch sind diese sehr schwer und Störungsanfällig. Außerdem können diese Systeme nur aufwendig in eine elektrische oder elektronische Umgebung implementiert werden.

Aus der DE 10 2007 017 624 B4 ist eine thermoelektrische Temperiervorrichtung mit mehreren thermoelektrisch arbeitenden Temperierelementen bekannt. Auch die US 3,552,133 A und die US 4,463,569 A zeigen thermoelektrische Temperiervorrichtungen mit thermoelektrischen Temperierelementen, entlang denen Luftströmungskanäle mit darin angeordneten Lüftern gebildet sind.

Eine weitere thermoelektrische Temperiervorrichtung ist in der DE 4190137 B4 angegeben. Bei dieser Vorrichtung sind mehrere Peltierblöcke, die mit ihrer Kette und heißem Seil mit je einem Wärmetauscher in wärmeleitender Verbindung stehen, von einer Wärmeisolierung umgeben, die jeweilige Luftströmungskanäle bilden. Mittels eines Axialgebläses wird in Längsrichtung der Strömungskanäle ein Luftstrom erzeugt, der von einem Einlass zu einem Auslass geradlinig geführt ist.

Aus dem DE 200 07 920 U1 ist eine Temperiervorrichtung in Zusammenhang mit einer Belüftungsvorrichtung für ein Gehäuse bekannt. Der aktiv arbeitenden Peltier-Wärme-Übertragungseinrichtung ist eine separate Strömungskammer mit einem Wärmetauscher im Strömungsweg vorgelagert, dem wiederum ein Radiallüfter zum Zuführen eines internen Luftstromes vorgeschaltet ist. Die gesamte Belüftungsvorrichtung bildet zusammen mit den Luftströmungskammern eine relativ voluminöse Einheit.

Aus der DE 101 23 456 A1 ist zur Verbesserung des Wärmetauschers ein Wärmetauscher aus einem offenporigen Metallschaum bekannt, bei dem die Zellen derart miteinander verbunden sind, dass ein fluides Medium durch den Metallschaum hindurch fließen kann. An den Metallschaum ist ein Bauelement stoffschlüssig angegossen. Das Bauelement kann als Platte ausgebildet sein, wobei die Platte selbst keine Poren aufweist, sondern als Vollmaterial gebildet ist.

Aus der DE 10 2014 118 177 A1 ist ein Verfahren zum Herstellen eines metallischen Formkörpers, ein metallischer Formkörper und ein Verfahren zum Ausbilden eines Bauteils mit einem Wärmetauscher bekannt. Der metallische Formkörper umfasst zumindest einen schaumartigen Bereich, wobei die strukturellen Eigenschaften des Metallschaumes, wie Porengröße, Stegbreite, Porenform etc. gezielt vorgebbar sind. Der metallische Formkörper wird vollständig mittels 3D-Druck aus einem metallischen oder metallhaltigen Rohmaterial schichtweise in seiner dreidimensionalen Form gedruckt.

Die DE 103 24 190 B4 beschreibt einen Wärmetauscher umfassend zumindest einen Kühlkörper aus offenporigem Metallschaum, dessen Oberfläche mit einer Metallfolie bedeckt ist, die sich in Kontakt mit einem zu kühlenden Bauelement befindet, wobei die Metallfolie eine kanalartige Strukturierung aufweist, sodass ein Kühlmittel durch die Folie geführt werden kann und die Metallfolie in den Metallschaum eingepresst ist.

Nachteilig ist bei derart hergestellten Wärmetauschern, dass aufgrund der stochastisch verteilten Poren, Porengrößen und Stegbreiten eine gezielte Strukturanpassung des Schaumes nur in einem eingeschränkten Maße möglich ist.

Die US 2008/0149304 A1 beschreibt ein Verfahren zur Herstellung einer Wärmetauscherkomponente, umfassend die Schritte: Erzeugen einer Stereolithographiedatei aus Konstruktionsdaten; Schneiden der Stereolithographiedatei in zweidimensionale Muster; sequntielles Wiederholen der zweidimensionalen Muster, um eine dreidimensionale Kernkomponente zu erzeugen und Abschneiden mindestens einer Schicht eines Materials mit einer hohen Wärmeleitfähigkeit auf einer oberen Oberfläche einer Basis. Weiterhin wird ein Wärmetauscherkern, hergestellt nach dem Verfahren, beschrieben, dass eine Kernkomponente umfassend ein dreifach periodisches Design umfasst, welches sich in drei Dimensionen wiederholt.

Die US 2010/0218512 A1 beschreibt einen Wärmetauscher für thermoelektrische Anwendungen umfassend mindestens einen Schaumwärmetauscher zur Verbesserung der Wärmeübertragung in thermoelektrischen Systemen. Derartige Schaumwärmetauscher bestehen aus gut leitenden Materialen, beispielsweise Aluminium, Kupfer oder Graphit, welches zu einem Körper aufgeschäumt wird.

Die WO 2013/163398 A1 beschreibt einen additiv hergestellten Wärmetauscher mit einer Gitterstruktur, dessen Wärmetauscherrohre Gitterstrukturen aus intermitierenden, sich wiederholenden Formen umfassen.

Die DE 100 55 454 A1 beschreibt einen Kühlkörper mit einem Wärmeaufnahme- und einem Wärmeabgabebereich, wobei der Wärmeabgabebereich durch einen Metallschaumkörper gebildet wird.

Aufgabe der Erfindung ist es, Festkörper und/oder Behältnisse mit einer Struktur zur Temperierung mittels Luftstrom und / oder mit thermoelektrisch arbeitenden Temperierelementen in Form eines Wärmetauschers so weiterzuentwickeln, dass diese insbesondere zum Kühlen, aber auch zum Heizen, geeignet ist, wobei diese flexibel gestaltet werden können, ein geringes Gewicht und eine geringe Größe aufweisen und die Struktur in ihrer Dichte und Auslegung innerhalb desselben Objektes so angepasst werden kann, dass eine gesteuerte Temperierung an besonders beanspruchten Teilen ermöglicht wird. Des Weiteren soll die Struktur von Anwendern für verschiedene Zwecke mit möglichst wenig Aufwand einsetzbar sein und einfache Erweiterungs- und Anpassungsmöglichkeiten bieten.

Erfindungsgemäß wird die Aufgabe durch einen Festkörper oder ein Behältnis mit einer Struktur zur Temperierung mittels Luftstrom und / oder mit thermoelektrisch arbeitenden Temperierelementen mit den Merkmalen des Anspruchs 1 gelöst. Vorteilhafte Weiterbildungen der Erfindung ergeben sich aus den Unteransprüchen und der nachfolgenden Beschreibung. Gemäß der Erfindung ist der Festkörper oder das Behältnis, die einer Temperierung bedürfen, in einem Stück mit der Struktur innerhalb oder außerhalb angefertigt. Die Struktur weist eine regelmäßige und / oder variable Anordnung von polyedrisch ausgeformten Hohlräumen mit innenliegenden Verstrebungen von variabler und / oder regelmäßiger Anordnung und Dichte als Luftkanäle auf. Die Dichte kann in allen Raumachsen variieren und kann auch an räumlich spezifizierte Anforderungen angepasst werden.

Die eingearbeiteten Luftkanäle sind innerhalb der Struktur chaotisch angeordnet, wodurch die durchströmende Luft zu einem verstärkten Kontakt mit der Oberfläche gezwungen wird. Durch entstehende Verwirbelungen im Luftstrom wird die Übertragung der Wärmeenergie wesentlich verbessert.

Die Größe und die Luftdurchlässigkeit können an die räumliche Verteilung der benötigten Energieübertragung angepasst werden.

Des Weiteren kann eine aktive thermoelektrische Temperierung auf Basis des Peltier- oder des Thomson-Effektes in die Struktur integriert werden. Die gleiche Konfiguration kann auch zum Erzeugen elektrischer Spannungen mittels des Seebeck-Effekts genutzt werden. Zur Ausnutzung des vorgenannten ist mindestens ein Peltier-Element vorgesehen, wobei einzelne oder mehrere Komponenten in die Struktur integriert sind.

Die erfindungsgemäße Struktur ist mittels der additiven Konstruktion in Form des 3D-Druckes erstellbar und kann beispielsweise für die Temperierung von elektrischen, elektronischen oder mikroelektronischen Elementen sowie für die Temperierung von Batteriegehäusen verwendet werden.

Die durch die additive Konstruktion (3D-Druck) erstellte Struktur weist eine variable Dichte und Form auf, wobei diese an einer oder mehreren Stellen so geformt sind, dass sich eine maximale Paßform zum zu temperierenden Objekt ergibt. Bei Anwendung zur Temperierung von Flüssigkeiten und / oder Gasen kann das gesamte Objekt, bestehend aus Wandung und Struktur aus einem Stück so hergestellt werden, dass die Verbindung zwischen Behälter und Wandung auf molekularer Ebene stattfindet. Die Struktur kann in ihrer Dichte und Auslegung innerhalb desselben Objektes so angepasst werden, dass eine gesteuerte Temperierung an besonders beanspruchten Teilen ermöglicht wird.

Die Erfindung gemäß der ausgebildeten Struktur ist sowohl für eine passive als auch für eine aktive Kühlung bzw. Erwärmung (Temperierung) der Objekte ausgelegt.

Durch spezifische Anpassung der Objektmerkmale wie Material, Form, Dichte und deren Verteilung sowie der Einsatz parametrischen Designs mittels mathematischer Formeln zur Erstellung komplexer, quasifraktaler Strukturen wird die Temperierungseffizienz um ein Vielfaches erhöht.

Die Anforderungen an die Struktur können durch Finite-Element-Model-Simulationen schon in der Entwicklungsphase ermittelt werden. Diese Simulationsdaten können der Berechnung als Vorgaben eingegeben werden, um die Struktur räumlich anzupassen.

Die Effizienz der Temperierungsstruktur kann durch Anpassung der nachfolgenden Faktoren optimiert werden.

Die Wärmeleitfähigkeit und das Wärmespeichervermögen (auch Wärmesenkung genannt) wird über die Materialauswahl beeinflußt.

Das Wärmeabgabevermögen wird durch die Form und die Dichte der Struktur bestimmt.

Die aktive Kühlung erfolgt in Verbindung mit mindestens einem Peltier-Element. Mit dem Peltier-Effekt kann die Struktur entweder aktiv erwärmt oder gekühlt werden, oder auch die entstehenden Temperaturdifferenzen in elektrischen Strom zurück transformiert werden. Die Möglichkeit, die Außenseiten mit einer oder mehreren Komponenten des Peltier-Elements zusammen mit der Struktur und der Kontaktfläche in einem Stück zu erzeugen, bietet die Möglichkeit für eine hocheffektive aktive Wärme-/Kälteübertragung.

Durch den Einsatz der Erfindung kann bei vielen Applikationen auf eine Flüssigkeitskühlung verzichtet werden, was die Komplexität der Konstruktion besonders im Bereich der elektronischen Geräte und der Elektro-Mobilität erheblich vereinfacht. Die problematische Nähe von Flüssigkeiten zu elektrischen Leitern kann durch die Erfindung beseitigt werden. Die Leistung elektronischer Bauteile kann erhöht werden ohne an thermische Grenzen zu stoßen. Das Gewicht mobiler Anwendungen wird verringert sowie ihre Einsatzmöglichkeiten vervielfacht.

Durch die Erstellung von zum Beispiel einem Behälter für Stoffe inklusive der Struktur aus einem Stück besteht eine molekulare Verbindung, die die Wärmediffusion erheblich positiv beeinflußt im Vergleich zu herkömmlichen Methoden wie Wärmeleitpasten.

Beim Einsatz aktiver thermoelektrischer Temperierung kann sogar die Kontaktfläche des Peltier-Elements in einem Stück mit dem Kühlkörper und der Behälterwand kombiniert hergestellt werden. Dabei können auch Übergänge von gekrümmten zu ebenen Flächen realisiert werden und so der Peltier-Effekt verbessert werden. Im Umkehrbetrieb können so aus Temperaturdifferenzen mittels des Seebeck-Effektes elektrische Ströme erzeugt werden, entweder zu Messungszwecken oder auch zum Betrieb bestimmter elektronischer Komponenten eines Systems oder gar der Luftzirkulation eines Temperierungssystems.

Dadurch ist es möglich, bisher industriell unmöglich herstellbare komplexe Strukturen auch auf kleinstem Raum zu realisieren und die thermische Effizienz von Energieflüssen zu verbessern. Die kontinuierliche Weiterentwicklung der 3D-Drucktechniken im Bereich Material und Druckauflösung lassen eine Festlegung auf bestimmte Technologien der additiven Fertigung nicht zu.

Ein Temperiersystem bestehend aus Behälter / Kontaktfläche, Struktur und gesamten Peltier-Element, bestehend aus Keramikplatten, Metallkontakten und Halbleitern kann zukünftig durch SLS-Drucksysteme oder kombinierten Druckern aus einem Stück gefertigt werden und so komplette Freiheit bei der Formgebung ermöglichen. Dies wird zu einer enormen Leistungssteigerung der Temperierung führen, was zum Beispiel Mikroprozessoren eine höhere Spannung erlaubt, ohne dass die entsprechende Abwärme zu einem konstruktiven Problem wird. Durch den Einsatz statistischer Berechnung können proaktive Temperierungssysteme eingesetzt werden, die lokale Temperaturen gezielt beeinflussen. Dadurch können auch auf kleinerem Raum Kondensationsprozesse besser und schneller gesteuert werden.

In Kombination mit Berechnungen zu Statik und Vibrationsverhalten können entsprechende Simulationen die Form der Struktur so beeinflussen, dass statische Funktionen übernommen werden, um Gewicht einzusparen, und die Vibrationsfestigkeit der Gitterstruktur so angepasst werden, dass auch mobile Anwendungen unter erschwerten Bedingungen ermöglicht werden. So kann diese Technologie eingesetzt werden in mobilen Computern, im Maschinenbau, der Medizin, Pharmaindustrie und allgemein der chemischen Industrie, Raffinerien usw. wobei die Entwicklung hier nur durch die Weiterentwicklung der Drucktechnologien beeinflußt wird, sowie den Entwicklungen der Simulationsmathematik sowie parametrischen Berechnungsmodelle.

Anhand von Beispeilen soll die Erfindung näher erläutert werden.

Es zeigen:
Figur 1 a, b - gedruckte Struktur zur Temperierung nicht erfindungsgemäß
Figur 2 a, b - gedruckte Struktur für ein Kühlrohr nicht erfindungsgemäß
Figur 3 a, b - gedruckte Kühl- oder Wärmkörper nach der Erfindung
Figur 4 a, b - gedruckte Kühlkörper nicht erfindungsgemäß
Figur 5 a, b, c - chaotische Struktur

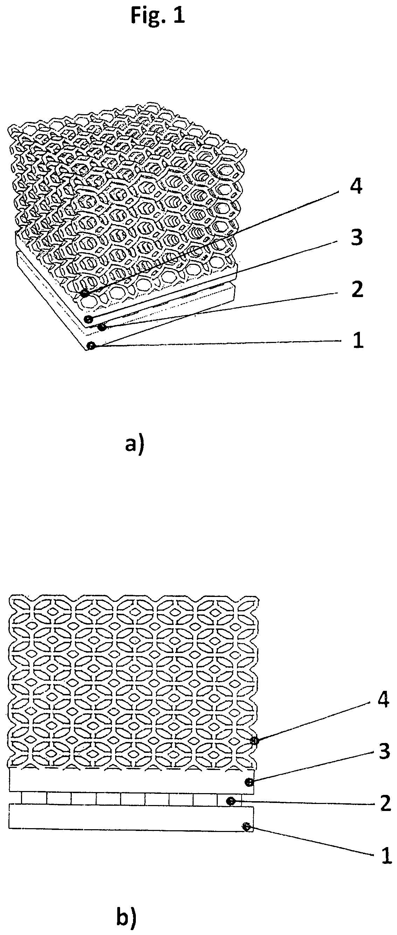

Die Figur 1 a und b zeigen ein gedrucktes Temperierelement in Verbindung mit einem Peltier-Element, wobei das Temperierelement aus einem Material mit höherer Wärmeleistfähigkeit besteht. Das Temperierelement besteht aus einer Kathode **1** des Peltier-Elements, einen p-dotiertem Halbleiter **2,** der Anode **3** des Peltier-Elements und der Struktur **4.** Diese Konfiguration verdeutlicht die Einsatzmöglichkeiten zur Temperierung z. B. eines Luftstromes. Die Bestandteile Anode **3** und Struktur **4** können auch aus einem Stück mittels additiver Herstellung im 3D-Druckverfahren erzeugt werden, um den Energiefluß zu verbessern.

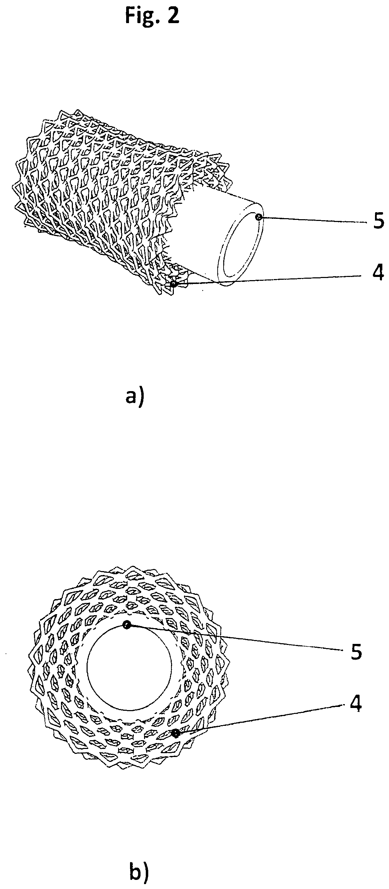

Die Figur 2 a und b zeigt eine gedruckte Struktur **4** für ein Kühlrohr **5**, geeignet zur Dissipation von Wärmeenergie aus fließenden und / oder gasförmigen Medien. Die Dissipationsfläche weist innerhalb der Struktur **4** eine große Oberfläche auf. Die Struktur **4** ist in einem Stückgedruckt, um eine hohe Übertragungsrate zu gewährleisten.

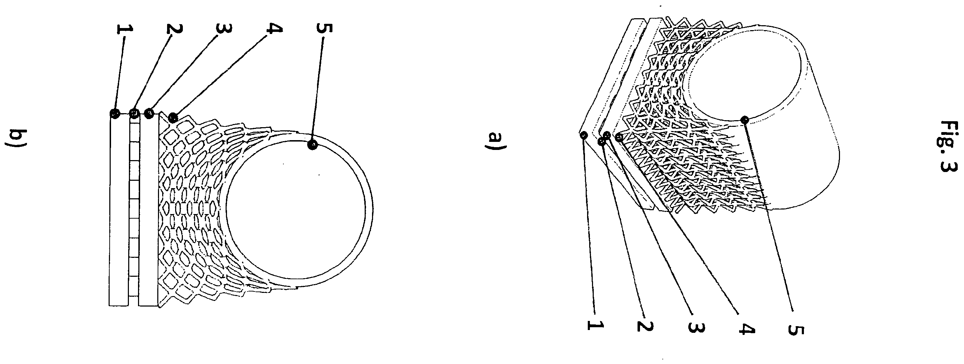

Die Figuren 3 a und b zeigen einen gedruckten Kühl- oder Wärmkörper für flüssige Materialien. Der Kühl- oder Wärmköper besteht aus einem Kühlrohr **5**, auf dessen Außenseite teilweise eine Struktur **4**, die mittels des 3D-Druckverfahrens auf die Oberfläche aufgebracht ist, angeordnet ist. Auf der dem Kühlrohr **5** entgegengesetzten Seite der Struktur **4** ist eine Anode **3** des Peltier-Elements in Verbindung mit einem p-dotierten Halbleiter **2** und der Kathode **1** des Peltier-Elements angeordnet. Bei der dargestellten Konfiguration können die Komponenten Anode **3** und Struktur **4** oder die Komponenten Anode **3,** Struktur **4** und Kühlrohr **5** miteinander kombiniert gedruckt werden.

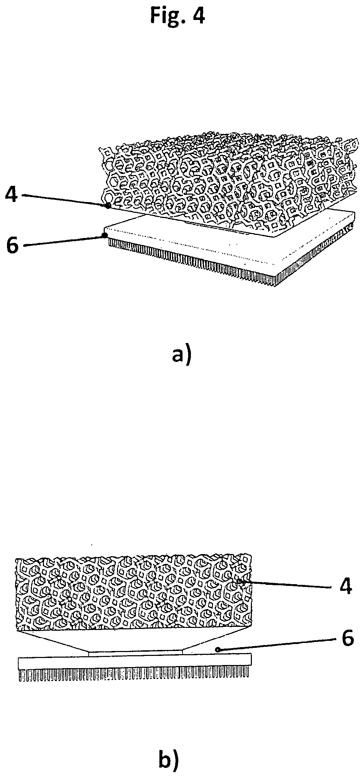

Die Figuren 4 a und b zeigen einen gedruckten Kühlkörper mit einer quaderförmigen Struktur **4** für elektronische Anwendungen, wobei der Kühlkörper aus einem nichtleitenden, hoch wärmeleitenden Material besteht und mit dem Prozessor **6** verbunden ist.

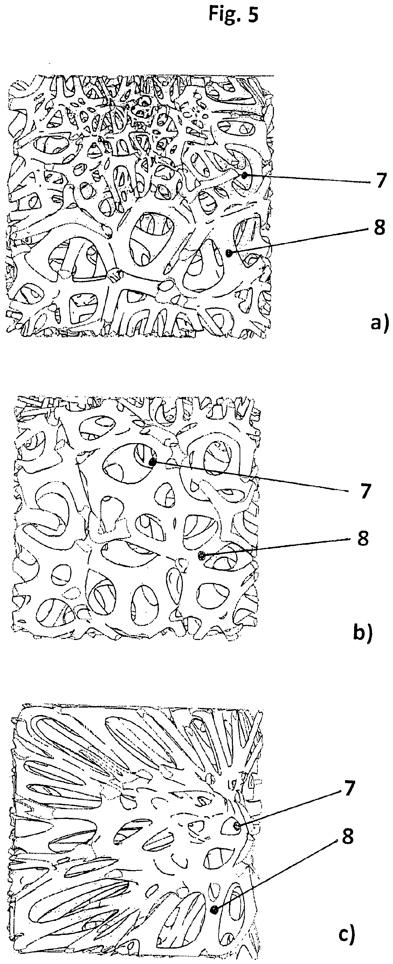

Die Figuren 5 a, b und c zeigen verschiedene Ausführungen der innerhalb der Struktur **4** chaotisch angeordneten Luftkanäle **7.**

Durch die Dichte und die Anordnung der innenliegenden Verstrebungen **8** kann die Kühlung des zu temperierenden Objektes beeinflußt werden, wobei die Wärmeübertragung durch strömende Gase ausgenutzt wird.

### Bezugszeichenaufstellung

- 1 -: Kathode
- 2 -: p-dotierter Halbleiter
- 3 -: Anode
- 4 -: Struktur
- 5 -: Kühlrohr
- 6 -: Prozessor
- 7 -: Luftkanal
- 8 -: Verstrebungen

## Patentansprüche

1. Festkörper oder Behältnis mit einer Struktur zur Temperierung des selben mittels Luftstrom und mit thermoelektrisch arbeitenden Temperierelementen, wobei der Festkörper oder das Behältnis in einem Stück mit der Struktur innerhalb oder außerhalb durch 3D-Druckverfahren angefertigt sind, wobei die Struktur (4) eine regelmäßige und / oder variable Anordnung von polyedrisch ausgeformten Hohlräumen mit innenliegenden Verstrebungen (8) von variabler und / oder regelmäßiger Anordnung und Dichte als Luftkanäle (7) aufweist, die eingearbeiteten Luftkanäle (7) innerhalb der Struktur (4) chaotisch angeordnet sind, und eine thermoelektrische Temperierung auf Basis eines Peltier- oder eines Thomson-Effekts in die Struktur (4) integriert ist.

2. Festkörper oder Behältnis nach Anspruch 1, **dadurch gekennzeichnet, dass** die Struktur (4) zur thermoelektrischen Temperierung mit mindestens einem Peltier-Element kombiniert ist, wobei einzelne oder mehrere Komponenten des Peltier-Elements in die Struktur (4) integriert sind.

3. Festkörper oder Behältnis nach Anspruch 1, **dadurch gekennzeichnet, dass** der Festkörper ein Kühlrohr (5) ist und zusammen mit der Struktur (4) und einer Anode (3) des Peltier-Element miteinander kombiniert gedruckt ist.

## Claims

1. Solid body or container comprising a structure for controlling the temperature thereof by means of an air flow and thermoelectrically operating temperature control elements, wherein the solid body or the container is manufactured in one piece with the structure on the inside or on the outside by 3D pressure moulding, wherein the structure (4) has a regular and/or variable arrangement of polyhedrally moulded cavities with internal struts (8) of variable and/or regular arrangement and density serving as air ducts (7), the incorporated air ducts (7) being arranged chaotically within the structure (4), and a thermoelectric temperature control based on a Peltier or Thomson effect being integrated into the structure (4).

2. Solid body or container according to claim 1,
**characterised in that**
the structure (4) for thermoelectric temperature control is combined with at least one Peltier element, wherein individual or multiple components of the Peltier element are integrated into the structure (4).

3. Solid body or container according to claim 1,
**characterised in that**
the solid body is a cooling tube (5) that is printed together and in combination with the structure (4) and an anode (3) of the Peltier element.

## Revendications

1. Corps solide ou récipient avec une structure pour la régulation de la température de celui-ci au moyen d'un courant d'air et des éléments de régulation de la température fonctionnant de manière thermoélectrique, le corps solide ou le récipient étant fabriqué en une pièce avec la structure disposée à l'intérieur ou à l'extérieur par un procédé d'impression 3D, dans lequel la structure (4) présente une disposition régulière et/ou variable de cavités de forme polyédrique avec des entretoises intérieures (8) d'arrangement et de densité variables et/ou réguliers servant de canaux d'air (7), les canaux d'air (7) usinés étant disposés de manière chaotique à l'intérieur de la structure (4), et un équilibrage de température thermoélectrique basé sur un effet Peltier ou un effet Thomson étant intégré dans la structure (4).

2. Corps solide ou récipient selon la revendication 1,
**caractérisé en ce que**
la structure (4) est combinée avec au moins un élément Peltier pour la régulation thermoélectrique de la température, des composants individuels ou multiples de l'élément Peltier étant intégrés dans la structure (4).

3. Corps solide ou récipient selon la revendication 1,
**caractérisé en ce que**
le corps solide est un tube de refroidissement (5) qui est imprimé ensemble et en combinaison avec la structure (4) et une anode (3) de l'élément Peltier.
